# EUROPEAN PATENT SPECIFICATION

(11) **EP 1 515 427 B1**
(45) Date of publication and mention of the grant of the patent: **06.11.2019**
(21) Application number: 04021458.7
(22) Date of filing: 09.09.2004
(51) Int. Cl.: H03B 5/18

(54) **Wideband tunable voltage controlled oscillator**
Breitbandstimmbarer spannungsgesteuerter Oszillator
Oscillateur commandé en tension accordable à bande large

(30) Priority: 09.09.2003 US 501371 P; 10.09.2003 US 501790 P; 09.12.2003 US 527957 P; 11.12.2003 US 528670 P; 19.04.2004 US 563481 P
(43) Date of publication of application: 16.03.2005
(73) Proprietor: Synergy Microwave Corporation, Paterson, N.J. 07504 (US)
(72) Inventor: Rohde, Ulrich L., Upper Saddle River NJ 07458 (US); Poddar, Ajay Kumar, Fairlawn NJ 07410-6110 (US)
(74) Representative: Körfer, Thomas

(56) References cited:
- US-A- 4 527 130
- US-A- 4 868 526
- US-A- 5 373 264
- US-A- 5 402 087

## Description

### CROSS-REFERENCE TO RELATED APPLICATIONS

This application claims the benefit of the filing date of U. S. Provisional Application Nos. 60/501,371, filed on September 9, 2003; 60/501,790, filed on September 10, 2003; 60/527,957, filed on December 9, 2003; 60/528,670, filed on December 11, 2003; and 60/563,481, filed on April 19, 2004.

### FIELD OF THE INVENTION

In one aspect, the present invention relates to circuitry for voltage controlled oscillators (VCOs). Preferably, such oscillators have one or more of the following characteristics: ultra-low phase noise performance, power efficient, low cost, tunable with more than octave-band tunability and amenable to integrated chip form.

### BACKGROUND

A voltage controlled oscillator (VCO) or oscillator is a component that can be used to translate DC voltage into a radio frequency (RF) voltage. The magnitude of the output signal is dependent on the design of the VCO circuit and the frequency of operation is determined by a resonator that provides an input signal. Clock generation and clock recovery circuits typically use VCOs within a phase locked loop (PLL) to either generate a clock from an external reference or from an incoming data stream. VCOs are therefore often critical to the performance of PLLs. In turn, PLLs are essential components in communication networking as the generated clock signal is typically used to either transmit or recover the underlying service information so that the information can be used for its intended purpose. PLLs are particularly important, in wireless networks as they enable the communications equipment to quickly lock-on to the carrier frequency onto which communications are transmitted.

The popularity of mobile telephones has renewed interest in and generated more attention to wireless architectures. This popularity has further spawned renewed interest in the design of low noise wideband oscillators. The recent explosive growth in the new families of cellular telephones and base stations using universal mobile telephone systems (UMTS) has stirred a need for developing an ultra-low noise oscillator with a fairly wide tuning range (e.g., octave-band). The demands of wideband sources have generally increased telescopically because of the explosive growth of wireless communications. In particular, modern communication systems are typically multi-band and multi-mode, therefore requiring a wideband low noise source that preferably allows simultaneous access to DCS 1800, PCS 1900 and WCDMA (wideband code division multiple access) networks by a single wideband VCO.

The dynamic operating range and noise performance of a VCO may limit or affect the performance of the PLL itself, which in turn may affect the performance of the device in which the PLL is employed, e.g., RF transceivers, cell phone, modem card, etc. Broadband tunability of VCOs represents one of the more fundamental tradeoffs in the design of a VCO, impacting both the technology and the topology used. The dynamic time average quality factor (i.e., Q-factor) of the resonator as well as the tuning diode noise contribution affect the noise performance of a VCO. Furthermore, the dynamic loaded Q is, in general, inversely proportional to the operating frequency range of the VCO.

Despite the continuous improvement in VCO technology, low phase noise typically remains a bottleneck and poses a challenge to RF transceiver (transmitter - receivers) design. This is typically considered due to the more demanding parameters of the VCO design: low phase noise, low power consumption and wide frequency tuning range.

In LC-resonator based VCOs, phase noise and power consumption typically depend primarily on the time average loaded Q-factor of the resonator circuit and the nonlinearities associated with the tuning network, which typically employ varactors. The frequency tuning range is determined by the usable capacitive tuning ratio of the varactor and parasitic associated with the tuning network because the parasitic deteriorates and limits the effective tuning capability of the varactor at a high frequency. As the loss-resistance of the tuning network (e.g., varactor and resonator) determines the quality factor, special attention is paid to the resistive behavior. The frequency range over which a coupled resonator circuit can be tuned by means of the tuning diode depends on the useful capacitance ratio of the tuning diode and on the parallel and series capacitance present in the circuit.

As the frequency for wireless communication shifts to higher and higher frequency bands, generation of an ultra-low noise, wideband, thermally stable and compact signal source at a relatively low cost becomes more and more challenging due to the frequency limitations of the active devices and broadband tunability of the tuning diode. In the past, wide tuning range and good phase noise performance were generally considered to be opposing requirements due to the problem of the controlling the loop parameters and the dynamic loaded Q of the resonator over the range of wideband operation.

Typically, the phase noise of a microstrip line resonator-based wideband VCO is -80dBc/Hz @10 KHz, (kilo-hertz) for a frequency band of 1600 - 3200 MHz (mega hertz) operating at 15V (volts), 45 mA (milli-ampere). A YIG resonator based VCO offers wideband tunability with an external DC magnetic field, but at a high price. In addition, the YIG resonator based VCO is not amenable to integration in chip form.

Thus, there is a need for a wideband oscillator, preferably having octave-band tunability, that offers a cost-effective alternative to the YIG resonator based wideband VCO in the frequency range of the L (0.95-1.5 GHz), S (1.7-2.3 GHz), and C (4-6 GHz) bands. Exemplary prior art oscillators are known from: US 4 527 130 A, US 4 868 526 A, US 5 402 087 A, and US 5 373 264 A.

### SUMMARY OF THE INVENTION

In view of the limitations of known active microwave devices and resonators for wideband operation, in one aspect the present invention provides a topology that supports wideband tunability in a compact size, which is amenable for implementation in integrated circuit form.

In another aspect, the present invention is a voltage controlled oscillator. The voltage controlled oscillator in accordance with this aspect of the present invention preferably comprises a first device having first, second and third terminals, a second device having first, second and third terminals and circuitry comprising tunable coupled resonator networks coupled to the second terminals of each of the devices through a tuning voltage network. Preferably, the voltage of the tuning network can be adjusted to tune an output signal of the voltage controlled oscillator over an octave frequency band.

Further in accordance with this aspect of the present invention, a bias network is desirably coupled between the first and third terminals of the first and second devices.

In accordance with this aspect of the present invention the oscillator further desirably comprises a dynamically tuned combiner network coupled between the third terminals of each of the devices to combine signals present: at the third terminals into an output signal tunable over an operating frequency range that is approximately twice the fundamental frequency.

Preferably, the first and second devices each comprise bipolar transistors, although field effect transistors (FET) may also be employed.

It is also desirable that the tunable resonator networks comprise a pair of micro-strip coupled resonators preferably arranged in a horse-shoe configuration.

Further in accordance with this aspect of the present invention, the voltage controlled oscillator is desirably provided in the form of an integrated circuit.

In accordance with an additional aspect of the present invention, a voltage controlled oscillator having octave band tunability is provided. The oscillator preferably comprises a first and a second three-terminal device; circuitry for a tunable phase coupling network coupled between respective first terminals of the first device and second devices; and circuitry for a dynamically tuned coupled resonator network coupled to respective second terminals of the first and second devices through a tuning voltage network. The voltage controlled oscillator in accordance with this aspect of the present invention may further desirably comprise a dynamically tuned combiner network coupled between respective third terminals of the first and second devices, wherein the dynamically tuned combiner network combines signals present at the third terminals of the first and second devices into an output signal that is tunable over an octave frequency band,

Further in accordance with the aspect of the present invention, the voltage of the tuning network may be adjusted to tune the frequency of the output signal over the octave frequency band. It is also desirable that the tunable resonator network circuitry comprise a pair of micro-strip coupled resonators arranged in a horse-shoe, configuration.

In accordance with yet another aspect of the present invention, an oscillator is provided. The oscillator preferably comprises a three terminal device arranged in a parallel emitter configuration and a resistance network coupled between a first terminal and a second terminal of the device. The resistance network is preferably capable of generating a negative resistance. The oscillator also further desirably includes a tuning voltage network coupled to the third terminal of the device through a coupled resonator network such that as the tuning voltage network is adjusted the operating frequency of the oscillator is tuned over a frequency band and the negative resistance generated is kept substantially uniform over the frequency band.

In accordance with yet another aspect of the present invention, a network communication device is desirably provided. The network communication device preferably comprises a phase lock loop for generating a clock signal used to transmit or recover information communicated from or to the device, wherein the phase lock loop includes a voltage controlled oscillator for generating the clock signal. The oscillator may further desirably comprise a first device having first, second and third terminals; a second device having first, second and third terminals; and circuitry comprising tunable coupled resonator networks coupled to the second terminals of each of the devices through a tuning voltage network, wherein the dynamically tuned combiner network combines signals present at the third terminals of the first and second devices into an output signal that is tunable over an octave frequency band.

In a further aspect, the present invention is a network communication device. The device preferably comprises a phase lock loop for generating a clock signal used to transmit or receive information communicated from or to the device. The phase lock loop preferably includes a voltage controlled oscillator comprising a three, terminal device arranged in a parallel emitter configuration and a resistance network coupled between a first terminal and a second terminal of the device. The resistance network is preferably capable of generating a negative resistance. The oscillator also further desirably includes a tuning voltage network coupled to the third terminal of the device through a coupled resonator network such that as the tuning voltage network is adjusted the operating frequency of the oscillator is tuned over a frequency band and the negative resistance generated is kept substantially uniform over the frequency band.

In accordance with this aspect of the present invention, the voltage of the tuning network is preferably adjusted to tune the frequency of the output signal over the octave frequency band. It may further prove desirable in accordance with this aspect of the present invention, if the device comprises a wireless device including a cellular telephone or a personal digital assistant.

Further still, in accordance with an additional aspect of the invention, a voltage control oscillator comprising a first three terminal device and a second three terminal device is provided, Each three terminal device includes first, second and third terminals. The first terminal of each of the devices is preferably coupled together through a tunable phase coupling network. Each of the second terminals of the devices is coupled to respective dynamically tuned coupled-resonator networks, which are preferably coupled together through a tuning voltage network. Each of the third terminals, of the devices are coupled to each other through a bias network, which is also coupled to the first terminal. A tunable output signal at the fundamental frequency of the circuit is tapped off each of the third terminals and preferably, combined in a dynamically-tuned combiner network. A tunable output signal operating at twice the fundamental frequency of the circuit is desirably obtained at the output of the dynamically-tuned combiner network.

Further in accordance with this aspect of the present invention, the circuit elements of the voltage controlled oscillator are preferably selected such that the fundamental frequency of operation of the circuit is tunable over 1000 MHz to 2000 MHz. In accordance this preferred aspect, the tunable output signal is tunable over a frequency range of 2000 MHz to 4000 MHz.

The three terminal devices may each preferably comprise bipolar transmitters, although field effect transistors may also be used.

In accordance with a further aspect of the present invention, the circuit elements comprising the voltage control oscillator are preferably selected and arranged in accordance with FIG. 2. In yet another aspect, the present invention is a voltage controlled oscillator preferably implemented in accordance with the schematic diagram of FIG. 3. In yet another aspect, the present invention is a voltage controlled oscillator preferably implemented in accordance with the schematic diagram of FIG. 4.

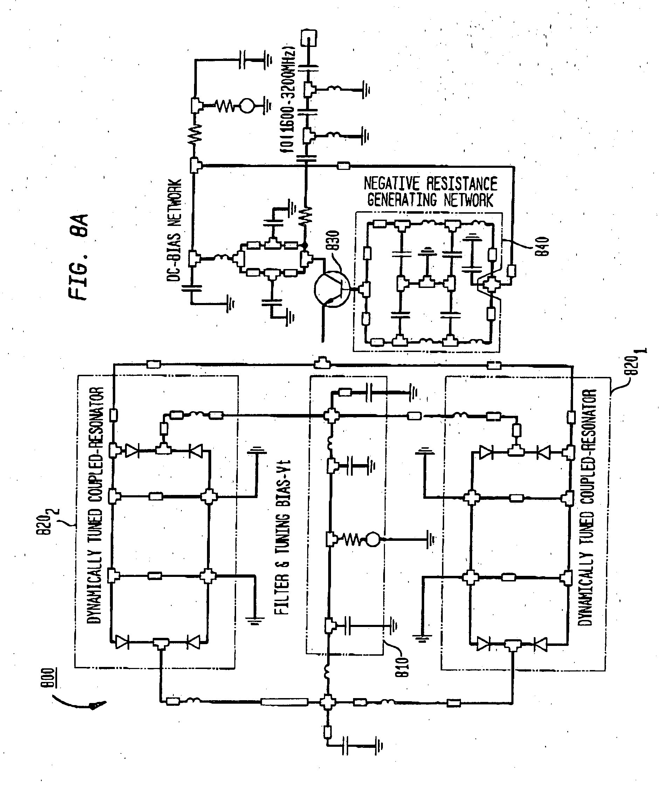

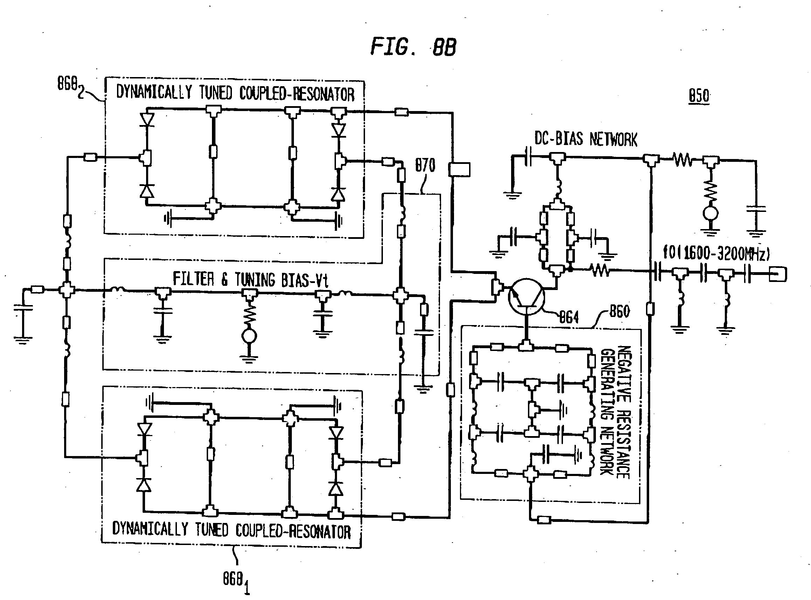

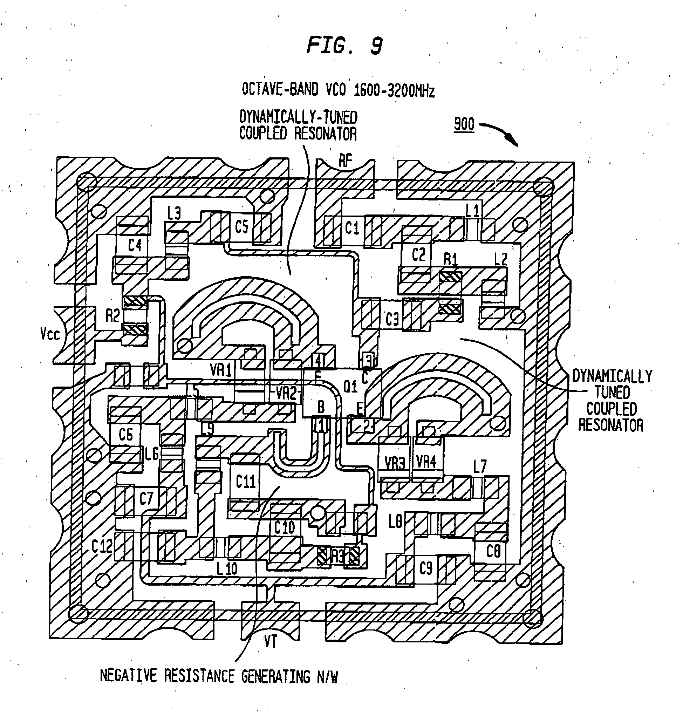

In another aspect, the present invention comprises a voltage controlled oscillator having a three terminal bipolar transistor in a parallel-emitter configuration. The base terminal of the transistor is coupled to a wideband negative resistance generating network, which is coupled across the collector terminal of the transistor. A DC-bias and filtering network is also coupled to the collector terminal. Circuitry comprising a pair of coupled resonators and tuning diodes are preferably coupled across the emitter terminal of the device through a filtering and tuning voltage network. In accordance with this aspect of the present invention, an output signal is , tapped from the collector terminal through a matching and output network. Further in accordance with this aspect of the present invention, the voltage controlled oscillator may be preferably implemented in accordance with FIG. 8. In addition, in accordance with this aspect of the present invention, the voltage controlled oscillator is preferably implemented or laid out in accordance with the schematic diagram shown in FIG. 9.

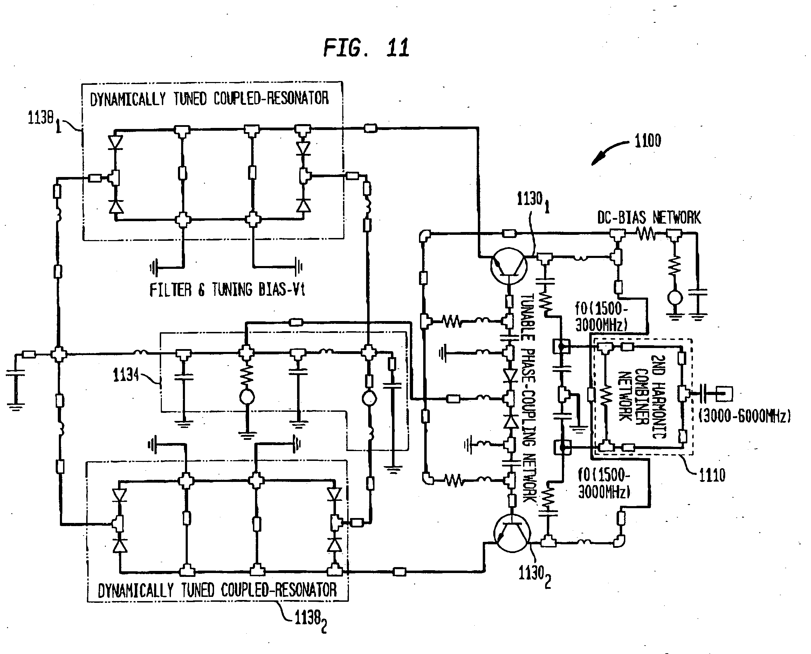

In accordance with yet another aspect of the present invention, a voltage controlled oscillator is provided. The oscillator preferably comprises a first three terminal device and a second three terminal device, each having a first, a second, and a third terminal. The first terminals of the devices are preferably coupled together through a tunable phase coupling network. In addition, the second terminal of each of the devices is coupled together through a tuning bias voltage network and respective dynamically tuned coupled resonator networks. The first and third terminals of each device are coupled together through respective bias networks. A tunable output operating at the fundamental' frequency, based on the values of the elements comprising the circuitry, present at the collector of each of the devices is coupled through a second harmonic combiner network. An output signal tunable over a range twice the fundamental frequency of operation results at the output of the combiner network. In a most preferred embodiment the output signal is tunable over a range comprising 3000 MHz to 6000 MHz. Further in accordance with this embodiment,' the voltage controlled oscillator is implemented in accordance with the circuit diagram of FIG. 11.

In another aspect, the present invention is a method for dynamically tuning an integrated coupled-resonator tuned network, negative resistance generating network, phase-coupling network and the second harmonic combiner network for the realization of an ultra low noise octave band voltage controlled oscillator. More particularly, the present invention discloses an innovative approach of dynamic tuning of a negative resistance-generating network, coupled-resonator tuning diode network, and n^{th} harmonic combiner network (n=2) for ultra low noise octave band operation. This approach may be implemented using any three terminal device such as bipolar transistors and field-effect transistors or any other three terminal device that may be implemented in the future.

In another aspect, the present invention offers a cost effective and power efficient solution (5V, 10mA) to the demand for a wideband oscillator, which is accomplished by dynamically tuning the transistor's stability factors and maintaining the time average loaded Q of the coupled resonator over the desired tuning band.

In accordance with a further aspect of the present invention, the coupled resonator and coupled oscillator topology opens up the door to the high frequency ranges and enables the realization of integrated silicon based systems operating at higher frequencies during wideband operation. Further in accordance with this aspect of the present invention the design, fabrication, and performance of a wideband voltage controlled oscillator that can satisfy the present demand for a low noise, wide tuning range, less harmonic content, manufacturing tolerance and miniaturization is provided.

Furthermore, the freedom of selection of the frequency-band of VCO implemented in accordance with the present invention, its compact size, low cost, low power consumption, and stability over the wide operating temperature range provides a technology that is attractive, for mobile communication applications.

In accordance with a further aspect of the present invention the effects that may limit the wideband tuning range and development of unique topology, which can support octave-band tunability are reduced.

A further aspect of the present invention is a compact, power efficient, ultra low noise and low thermal drift microwave octave-band VCO operating, for example, at 1600 MHz, 2000 MHz, and 3000 MHz with more than 100% tunable bandwidth. The phase noise performance of a VCO implemented in accordance with this aspect of the present invention is usually at least -94dBc @ 10KHz, typically better than -100 dBc, for the frequency band of 1600 - 3200 MHz, -90dBc/Hz@ 10KHz, typically better than -95 dBc, for the frequency band of 2000 - 4000 MHz and -85dBc/Hz@ 10KHZ, typically better than -90 dBc, for the frequency band of 3000 - 6000 MHz.

The present invention supports oscillations for more than octave band tenability without degrading the loaded Q of the circuit over the frequency band. A topology is desirably designed to increase the loaded time average quality factor over the frequency band by selecting an optimum coupling factor of the micro-stripline coupled-resonator structure.

In accordance with yet another aspect of the present invention, a system of coupled resonators is disclosed. The disclosed system advantageously enhances the time average loaded Q factor over the octave band. Application of this approach results in an integrated dynamically tuned-microstrip-coupled resonator based oscillator, which significantly improves the phase noise performance depending upon the coupling factor of the coupled resonator over the wideband range.

In addition, the basic topology is extended to a system of coupled voltage controlled oscillator for extending the frequency of operation of the dynamically tuned coupled resonator and this objective is accomplished by dynamically coupling the oscillator over the entire band in such a way that they mutually injection lock over the wideband (octave band).

With regard to the state of the art of the push-push/N-push oscillator, the present invention provides the general implementation of an octave-band dynamically tuned tunable coupled oscillator for an extended frequency range of operation.

The topology and circuitry of the various aspects of the present invention is desirably able to maintain the noise performance over a wide temperature range (-40°C to +85°C) throughout the octave-band of operation and the structure of the layout remains substantially the same for other higher frequency bands.

The foregoing and other aspects of the present invention preferably include a topology, which provides constant negative resistance over octave-band; a tuning arrangement for wideband tunability without degrading the loaded Q of the tuning network over the, octave-band; a coupled-resonator structure, which will support resonance over a octave-band; the optimum size (I_{cmax}/I_{das}) of the bipolar or FET for low phase noise; a coupled-oscillator/N-Push approach for improvement in phase noise; a second harmonic combiner circuit; a dynamically tuned phase coupling network.

### BRIEF DESCRIPTION OF THE DRAWINGS

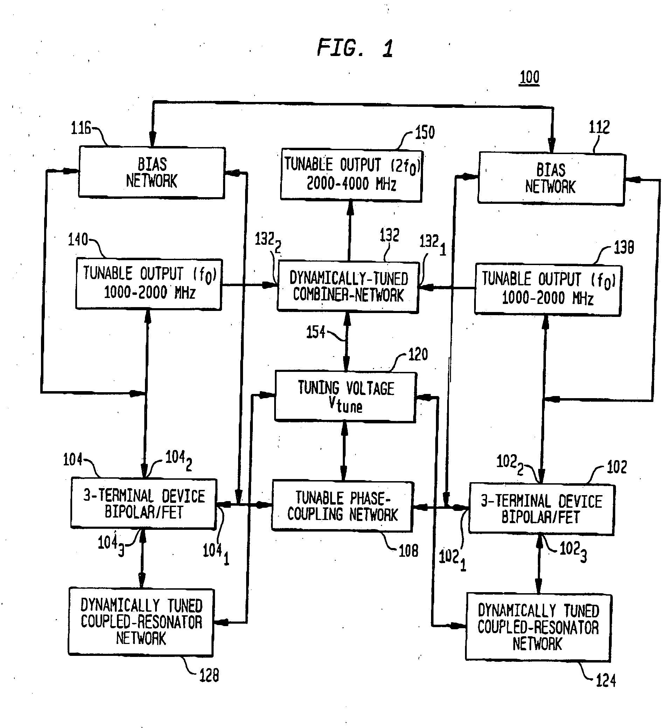

FIG. 1 is a functional block diagram illustrating the modules of a voltage controlled oscillator (VCO) in accordance with an aspect of the present invention.

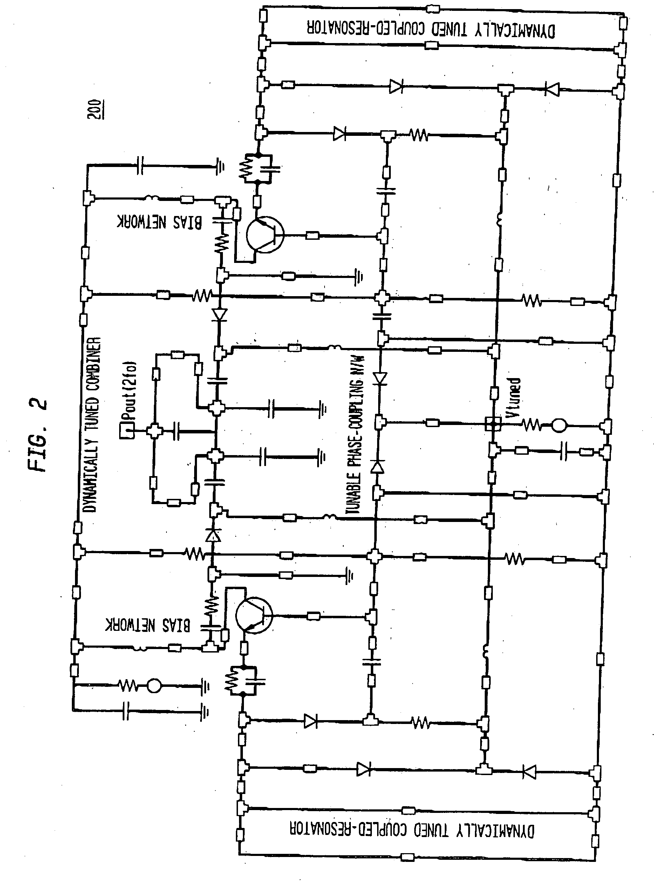

FIG. 2 is a schematic circuit diagram of VCO in accordance with an aspect of the present invention.

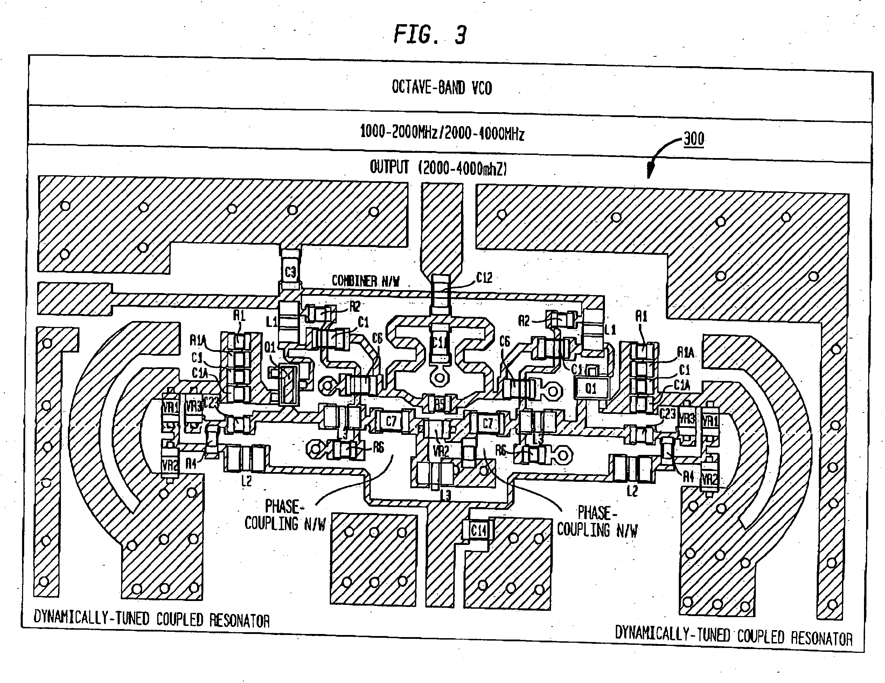

FIG. 3 is a schematic of an integrated circuit comprising a VCO in accordance with an additional aspect of the present invention.

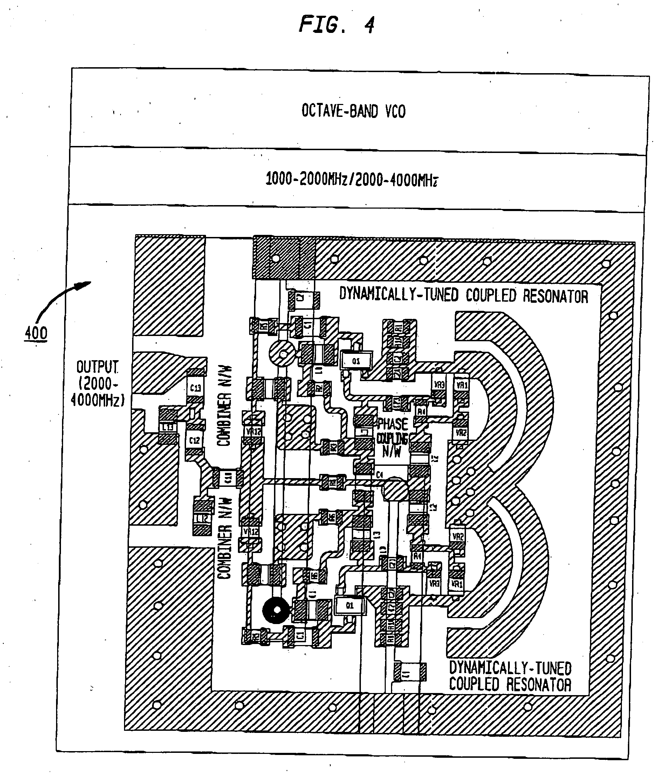

FIG. 4 is a schematic of an integrated circuit comprising a VCO in accordance with a further aspect of the present invention.

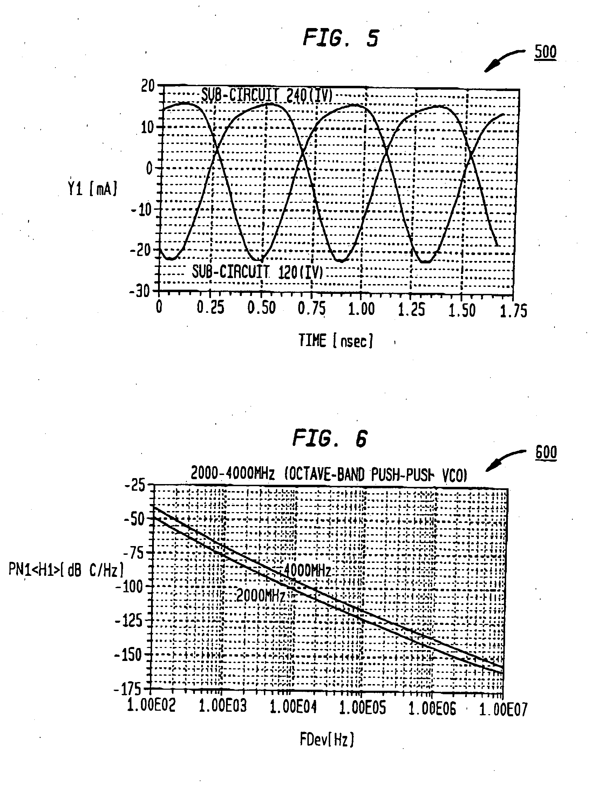

FIG. 5 is a plot of RF-base currents of the sub-circuits of FIG. 3 at the fundamental frequency of operation.
FIG. 6 shows a phase noise plot for a VCO over an octave-band frequency range of 2 GHz to 4 GHz in accordance with a further aspect of the present invention.

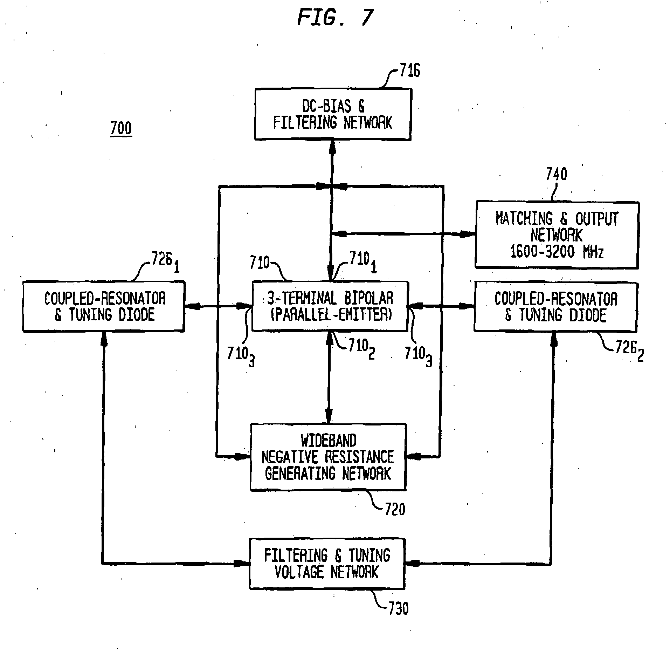

FIG. 7 is a functional block diagram illustrating the modules of a VCO in accordance with an aspect of the present invention.
FIG. 8A is a schematic circuit diagram of VCO in accordance with an aspect of the present invention.
FIG. 8B is a schematic circuit diagram of VCO in accordance with an aspect of the present invention.
FIG. 9 is a schematic of an integrated circuit comprising a VCO in accordance with another aspect of the present invention.

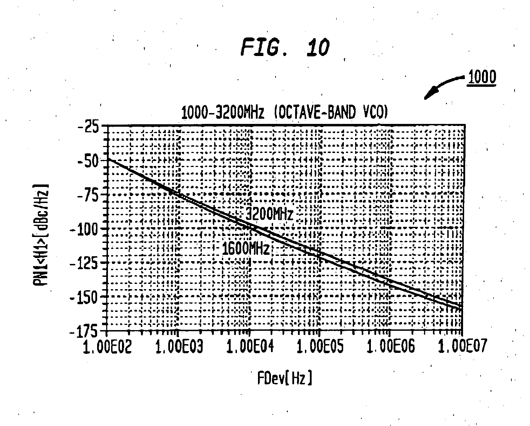

FIG. 10 illustrates a phase noise plot for the octave-band frequency range of a VCO in accordance with a further aspect of the present invention.
FIG. 11 is a schematic circuit diagram of VCO in accordance with an aspect of the present invention.

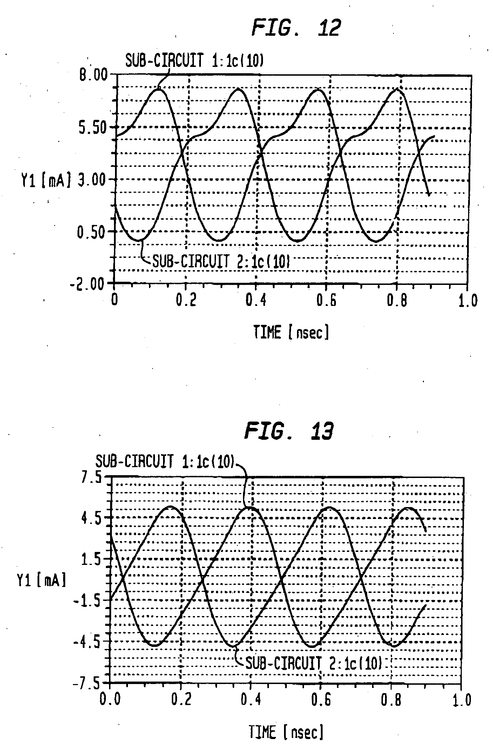

FIG. 12 is a plot of the RF-coliector current of the circuitry depicted in FIG. 12.
FIG. 13 is a plot of the RF-collector current of the circuitry depicted in FIG. 12.

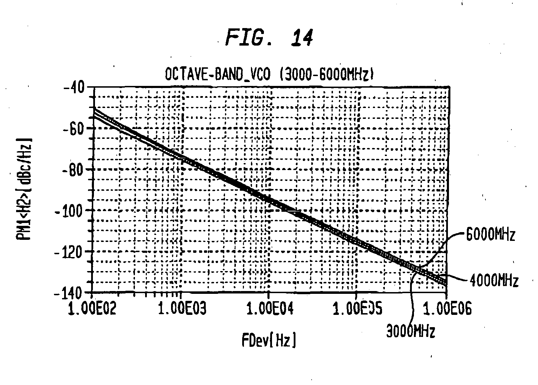

FIG. 14 illustrates a phase noise plot over an octave-band frequency range of 1.6 GHz to 3.2 GHz.

### DESCRIPTION OF THE PREFERRED EMBODIMENTS

FIG. 1 illustratively depicts a functional block diagram of the modules of a low noise octave-band voltage controlled oscillator (VCO) 100 in accordance with an aspect of the present invention. The VCO 100 is shown as operating in the frequency range of 1000 - 2000 MHz/2000 - 4000 MHz (i.e., 1 GHz - 2 GHZ/2 GHz - 4Ghz), although the individual circuit parameters, e.g., resistor values, capacitor values, etc., may be selected and arranged so that the circuit operates at a different fundamental frequency and produces a tunable output at both the fundamental frequency and second harmonic. In addition, the topology shown in FIG. 1 may be extended from a push-push type configuration, such as 1 GHz - 2 GHz/2 GHz - 4 GHz/ 4 GHz - 8 GHz/ 8 GHz - 16 GHz, which allows the operating frequency of the oscillator to be extended beyond the cut-off frequency of the active device.

As FIG. 1 shows, the VCO/oscillator 100 includes a pair of three terminal devices, 102 and 104, which are coupled together through the other modules shown. More particularly, each device 102 and 104 includes three terminals, illustrated as 102₁, 102₂ and 102₃ and 104₁, 104₂ and 104₃, respectively. The first terminal 102₁ of first device 102 is coupled to a tunable phase coupling network 108 and bias network 112. The tunable phase coupling network 108 is also coupled to the first terminal 104₁ of the second device 104, which is also coupled to a bias network 116 at terminal 104₁. The tunable phase coupling network 108 is also coupled to tuning voltage block 120. The tuning voltage block 120 is coupled to dynamically tuned coupled-resonator networks, 124, 128, which are respectively coupled to the third terminals 102₃, 104₃ of each of the three terminal devices.

The tuning voltage block 120 is further coupled to a dynamically-tuned combiner network 132, which includes two input ports, 132₁ and 132₂. Each of the input ports 132₁ and 132₂ accept input signals 138, 140 present at the second terminals 102₂ and 104₂ of each of the devices. The dynamically-tuned combiner network 132 combines the input signals 138, 140 and produces a signal 150 operating at the second harmonic of the input signals 138, 140.

The oscillator 100 preferably operates in the following manner. The circuit elements comprising the various modules, e.g., diodes, resistors, capacitors, resonators, etc., are selected so that each of the three terminal devices 102, 104 oscillate at a fundamental frequency, f0. As the voltage level of the tuning voltage module 120 is adjust the fundamental frequency of operation, f0, appearing as input signals 138, 140 is tuned over the operating range of the oscillator, e.g., preferably octave-band. These signals 138, 140 are then combined in the combiner network 132 to produce a signal operating at twice the fundamental frequency, 2f0, and that is dynamically tuned as the voltage level of the tuning voltage module 120 is adjusted. A select portion of a signal 154 from the combiner network 132 is also fed back to the tuning block 120. A portion of the signal 154 is then fed to tunable phase coupling network 108 anc used to dynamically tune the phase of the output signals 138. 140, so that each of these signals remain in phase during a tuning operation. In addition, a portion of the signal 154 is also fed to each of the dynamically-tuned coupled resonator networks 124, 128, so that the frequency, f0, present at block 138 is at the same frequency as the signal present at block 140. Accordingly, as the tuning voltage, Vtune, is adjusted the frequency of the signals, f0, present at each of the terminals 102₂ and 104₂ are tuned over the operating frequency band through the coupled resonator networks 124, 128, while the phase coupling network 108 keeps the two devices 102, 104 operating in an anti-phase mode at the fundamental frequency, f0 (e.g., push-pull behavior), while the second harmonic, 2f0, interferes constructively (e.g., push-push behavior) over the octave band.

FIG. 2 depicts a schematic circuit diagram 200 of a VCO designed in accordance with the principles of FIG. 1 in accordance with an additional aspect of the present invention. In particular, FIG. 2 illustrates a dynamically tuned coupled-resonator network, dynamically tuned phase-coupling network and dynamic tuned combiner network for octave-band 2-Push/ Push-Push operation.' Although FIG. 2 shows a 2-Push configuration the circuitry may be extended to a N-Push configuration and provide a tunable signal at N times the fundamental frequency of the sub-circuit's operation. The sub-circuits comprise the respective bias networks, resonator networks and three-terminal devices, which in this embodiment are depicted as bipolar transistors although FETs may be used also. The values of the individual circuit elements may chosen so that the resulting output signal from the circuitry operates in the L, S and C band and is tunable over a desired frequency band, preferably octave-band. This aspect of the present invention overcomes the limitations of the fixed frequency operation of the push-push oscillator/N-push oscillator by including a tuning and phase controlling network over the desired frequency band (preferably octave-band).

FIG. 3 illustrates a schematic layout of an integrated circuit (IC) 300 designed in accordance with the schematic circuit diagram of FIG. 2 with the values of the various circuit elements chosen such that the fundamental frequency is tunable over the frequency range of 1000 MHz to 2000 MHz (1 GHz to 2 GHz). In addition, the circuitry 300 also provides an output that is tunable over the frequency range of 2000 MHz to 4000 MHz (2 GHz to 4 GHz). As FIG. 3 shows the functional diagram of FIG. 1 and the circuitry of FIG. 2 are amenable to implementation as an integrated circuit. More particularly, the integrated circuitry of FIG. 3 includes a printed microstripline resonator and various discrete elements that may be preferably implemented in Roger material.

FIG. 4 illustrates a schematic layout of another integrated circuit 400 in accordance with the schematic circuit diagram of FIG. 2. As in FIG. 3, the various components of FIG. 2 are chosen such that the fundamental frequency is tunable over the frequency range of 1 GHz to 2 GHz. In addition, the integrated circuit 400 also provides an output that is tunable over the frequency range of 2 GHz to 4 GHz. In accordance with this aspect of the present invention, the sub-circuits of each of the resonators are configured in a push-push topology and each of the dynamically tuned coupled resonators is provided in integrated circuit form. THe form of the integrated circuit shown in FIG. 4 tends to be even more compact than that shown in FIG. 3.

As FIGS. 3 and 4 demonstrate a VCO designed in accordance with the foregoing aspects of the present invention may be implemented in the form of a compact integrated circuit, such as integrated circuits 300 and 400. The integrated circuits 300 and 400 may be advantageously mounted to a printed circuit or wire board in wireless devices, such as cell phones or a personal digital assistant, where space is at a premium. In addition, these devices preferably include octave band tunability, which allows for their deployment in applications such as WCDMA.

FIG. 5 illustrates a plot 500 of the RF-base currents of a voltage control oscillator of the type shown in FIGS. 3 or 4 at the fundamental frequency of operation. As FIG. 5 shows, the RF-base currents are out of phase for the fundamental frequency of the operation, 1000 - 2000 MHz.

FIG. 6 illustrates a typical phase noise plot 600 of an oscillator implemented in accordance with the circuitry illustrated in FIGS. 2, 3 or 4 for the octave-band frequency range of 2000 - 4000 MHz. As FIG. 6 shows the phase noise of the oscillator is approximately -90 dBc/Hz at 10 KHz over for the frequency band of 2000 - 4000. MHz. However, the integrated circuits 300, 400 typically provide better than -95 dBc/Hz at 10 KHz over for the frequency band of 2000 - 4000 MHz.

FIG. 7 is a functional block diagram illustrating the modules of alow noise octave-band VCO 700 in accordance with an additional aspect of the present invention. As shown in FIG. 7, the VCO includes a three terminal device 710 that includes terminals 710₁, 710₂ and 710₃. The device 710 is preferably configured as a parallel emitter transistor. The first terminal 710₁ is coupled to a DC-bias and filtering network 716. The second terminal 710₂ is coupled to a wideband negative resistance network 720, which is also coupled to the first terminal 710₁ of the device 710. The third terminal 710₃ of the device 710 is coupled to a pair of dynamically tuned coupled-resonator tuning diode networks 726₁ and 726₂ preferably through the parallel emitter of a three-terminal bipolar transistor. In FIG. 7, the third terminal 710₃ is shown twice on the device in order to simply the diagram, yet while illustrating the parallel emitter configuration. A filtering and tuning voltage network 730 is coupled between the dynamically tuned coupled-resonator tuning diode networks 726₁ and 726₂. The output signal of the VCO 700 is taken from a matching and output network 740 coupled to the first terminal 710₁ of the device.

In operation, the wideband negative resistance generating network 720 maintains a constant resistance over the tuning band of the oscillator 700. More particularly, the filtering and tuning network 730 is tuned to adjust the oscillation frequency of the device 710 through the coupled-resonator and tuning diode 726. As tuning occurs the negative resistance generating network 720 maintains uniform or constant negative resistance over the tuning band. In this way, the phase noise output of the oscillator may be maintained at a relatively low, e.g., ultra-low, level.

FIG. 8A shows a schematic circuit diagram 800 of a possible implementation of the functional diagram 700 of FIG. 7 in accordance with another aspect of the present invention. As FIG. 8A shows, a filter and tuning bias network 810 is integrated with a pair of coupled horse-shoe microstrip resonator (820₁ and 820₂). The tuning network 810 and negative resistance generating network 840 allows the VCO to be tunable over more than an octave-band while maintaining a uniform phase-noise performance through the band. The circuit elements are preferably chosen to provide tunability over a 1600 - 3200 MHz frequency band. The circuit elements may also be chosen to allow for,tunability over other octave bands as is discussed below.

FIG. 8B illustrates a schematic circuit diagram 850 of a possible implementation of the functional diagram 700 of FIG. 7 in accordance with yet another aspect of the present invention. The circuitry 850 of FIG. 8B includes a variable negative resistance generating network 860, which is preferably coupled to the base of a bipolar transistor 864. The transistor 864 is preferably arranged in a parallel emitter configuration with a pair of dynamically tuned coupled-resonators 868₁, 868₂ coupled in parallel to the emitter. A filter and tuning bias network 870 is coupled between the resonators 868₁ and 868₂ as shown. In accordance with this aspect of the present invention, the negative resistance generating network includes a pair a variable capacitors that allow the negative resistance to be variable over the tuning range. This in turns allows the value of resistance provided by the network 860 to be tunable over the tuning range of the oscillator.

FIG. 9 illustrates a schematic layout of an integrated circuit 900 designed in accordance with the embodiment illustrated FIG. 8A. The discrete elements and layout of the integrated circuit of FIG. 9 may be chosen to allow for more than octave band tunability over a 1.6 to 3.2 GHz operating frequency range.

FIG. 10 shows a phase noise plot 1000 for the octave-band frequency range of 1600 - 3200 MHz for the integrated circuit 900 of FIG. 9. As shown, the phase noise is approximately - 95dBc at 10 KHz, however the phase noise is typically better than -100dBc at 10 KHz.

FIG. 11 depicts a schematic circuit diagram of a low noise octave band VCO 1100 operating in the frequency range of 3000 - '6000 MHz in accordance with an additional aspect of the present invention. The circuit diagram of FIG. 11 is implemented in accordance with the functional diagram of the FIG. 1, however the circuit elements comprising the various modules are selected so as to provide a fundamental frequency of operation of 1500 to 3000 MHz. Accordingly, the second harmonic combiner network 1110 combines the signal at the fundamental frequency produced at the collectors, 1130₁ and 1130₂, of the transistors to produce a signal that is tunable over the frequency band of 3000 to 6000 MHz.

As FIG. 11 also shows, a dynamic tuning network 1134 which is integrated with coupled horse-shoe microstrip resonators 1138₁ and 1138₂ is incorporated to get more than octave band tunability while maintaining a uniform phase noise performance throughout the band.

FIG. 12 is a plot 1200 of the RF-collector current of both sub-circuits of FIG. 11, which are out of phase for the fundamental frequency of operation, 1500 - 3000 MHz.

FIG. 13 is a plot 1300 of the RF-base currents of both sub-circuits of FIG. 11, which are out of phase for the fundamental (undesired frequency of the operation, 1500 - 3000 MHz. FIG. 14 shows a phase noise plot 1400 for octave-band frequency range of 3000,- 6000 MHz for the circuitry shown in FIG. 11.

A voltage controlled oscillator implemented in accordance with the present invention may be employed in any number of devices that are used to communicate on data, telephone, cellular or, in general, communications network. Such devices may include but are not limited to, for example, cellular phones, personal digital assistants, modem cards, lap tops, satellite telephones. As a general matter, the oscillator circuitry shown in the various drawings and described above may be employed in a PLL to either generate a clock signal that may be used to transmit or recover information transmitted or received ever a network. In addition to wireless networks, the circuitry of the present invention may be employed in wired networks, satellite networks, etc.

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the scope of the present invention as defined by the appended claims.

## Claims

1. A voltage controlled oscillator, comprising:
a first device (102) having first, second and third terminals (102₁, 102₂, 102₃);
a second device (104) having first, second and third terminals (104₁, 104₂, 104₃); and
circuitry comprising a tuning voltage network (120) coupled to dynamically tuned coupled resonator networks (124, 128), which are respectively coupled to the third terminals (102₃, 104₃) of each of the devices (102, 104) and a dynamically-tuned combiner network (132), which includes two input ports (132₁,132₂) accepting a respective input signal (138,140) present at the second terminal (102₂,104₂) of each of the devices (102,104) and combines the input signals (138,140)) into an output signal (150), whereby the dynamically-tuned combiner network (132) is coupled to the tuning voltage network (120) for feeding back a select portion of a signal (154) from the dynamically-tuned combiner network (132) to the tuning voltage network (132),
wherein the voltage of the tuning network (120) can be adjusted to tune the output signal (150) of the voltage controlled oscillator over a frequency range of at least an octave.

2. The voltage controlled oscillator of claim 1,
further comprising a bias network (112, 116) coupled between the first and second terminals (102₁, 102₂; 104₁, 104₂) of the first and second devices (102, 104).

3. The voltage controlled oscillator of claim 1,
wherein the output signal (150) is tunable over an operating frequency range that is twice the fundamental frequency (2·f₀).

4. The voltage controlled oscillator of claim 1,
wherein the first and second devices (102, 104) each comprise bipolar transistors.

5. The voltage controlled oscillator of claim 1,
wherein the first and second devices (102, 104) each comprise field effect transistors.

6. The voltage controlled oscillator of claim 1,
wherein the tunable resonator networks (124, 128) comprise a pair of micro-strip coupled resonators arranged in a horse-shoe configuration.

7. The voltage controlled oscillator of claim 1
wherein the first device (102), second device (104) and circuitry are implemented in an integrated circuit.

8. A voltage controlled oscillator of claim 1, further comprising:
circuitry (108) for a tunable phase coupling, network coupled between respective first terminals (102₁, 104₁) of the first device and second devices (102, 104).

9. A network communication device, the device comprising:
a phase lock loop for generating a clock signal used to transmit or recover information communicated from or to the device,
wherein the phase lock loop includes a voltage controlled oscillator, corresponding to claims 1 to 8, for generating the clock signal.

10. The communication device of claim 9, wherein the communication device comprises a wireless device.

11. The communication device of claim 9, wherein the wireless device is a cellular telephone.

12. The communication device of claim 9, wherein the wireless device is a personal digital assistant.

## Patentansprüche

1. Ein spannungsgesteuerter Oszillator, aufweisend:
ein erstes Bauelement (102) mit einem ersten, einem zweiten und einem dritten Anschluss (102₁, 102₂, 102₃);
ein zweites Bauelement (104) mit einem ersten, einem zweiten und einem dritten Anschluss (104₁, 104₂, 104₃); und
eine Schaltung mit einem Abstimmspannungsnetzwerk (120) gekoppelt mit dynamisch abgestimmten gekoppelten Resonator-Netzwerken (124, 128), welche jeweils mit den dritten Anschlüssen (102₃, 104₃) der jeweiligen Bauelemente (102, 104) gekoppelt sind, sowie einem dynamisch abgestimmten Kombinator-Netzwerk (132), welches zwei Eingangskanäle (132₁, 132₂) hat, die ein jeweiliges, an dem zweiten Anschluss (102₂, 104₂) jedes der Bauelemente (102, 104) vorliegendes Eingangssignal (138, 140) aufnehmen, und die Eingangssignale (138, 140) zu einem Ausgangssignal (150) kombiniert, wodurch das dynamisch abgestimmte Kombinator-Netzwerk (132) mit dem Abstimmspannungsnetzwerk (120) gekoppelt ist, um einen ausgewählten Bereich eines Signals (154) von dem dynamisch abgestimmten Kombinator-Netzwerk (132) an das Abstimmspannungsnetzwerk (132) rückzukoppeln,
wobei die Spannung des Abstimmnetzwerks (120) zum Abstimmen des Ausgangssignals (150) des spannungsgesteuerten Oszillators über einen Frequenzbereich von mindestens einer Oktave eingestellt werden kann.

2. Der spannungsgesteuerte Oszillator nach Anspruch 1,
ferner aufweisend ein Vorspannungsnetzwerk (112, 116), das zwischen dem ersten und dem zweiten Anschluss (102₁, 102₂; 104₁, 104₂) des ersten und des zweiten Bauelementes (102, 104) gekoppelt ist.

3. Der spannungsgesteuerte Oszillator nach Anspruch 1,
wobei das Ausgangssignal (150) über einen Betriebsfrequenzbereich abstimmbar ist, welcher das Zweifache der Grundfrequenz beträgt (2 · f₀).

4. Der spannungsgesteuerte Oszillator nach Anspruch 1,
wobei das erste und das zweite Bauelement (102, 104) jeweils bipolare Transistoren aufweisen.

5. Der spannungsgesteuerte Oszillator nach Anspruch 1,
wobei das erste und das zweite Bauelement (102, 104) jeweils Feldeffekttransistoren aufweisen.

6. Der spannungsgesteuerte Oszillator nach Anspruch 1,
wobei die abstimmbaren Resonator-Netzwerke (124, 128) ein Paar von in Hufeisenform angeordneten, mikrostreifen-gekoppelten Resonatoren aufweisen.

7. Der spannungsgesteuerte Oszillator nach Anspruch 1,
wobei das erste Bauelement (102), das zweite Bauelement (104) und die Schaltung in einem integrierten Schaltkreis implementiert sind.

8. Ein spannungsgesteuerter Oszillator nach Anspruch 1, weiterhin aufweisend: eine Schaltung (108) für eine abstimmbare Phasenkopplung, die jeweils zwischen ersten Anschlüssen (102₁, 104₁) des ersten Bauelementes und des zweiten Bauelementes (102, 104) netzgekoppelt sind.

9. Ein Netzwerkkommunikationsgerät, wobei das Gerät Folgendes aufweist:
eine Phasenregelschleife zum Erzeugen eines Taktsignals, welches zum Übertragen oder Wiederherstellen von Informationen verwendet wird, die von dem oder auf das Gerät übertragen werden,
wobei die Phasenregelschleife einen spannungsgesteuerten Oszillator entsprechend den Ansprüchen 1 bis 8 zum Erzeugen des Taktsignals aufweist.

10. Das Kommunikationsgerät nach Anspruch 9, wobei das Kommunikationsgerät ein drahtloses Bauelement aufweist.

11. Das Kommunikationsgerät nach Anspruch 9, wobei das drahtlose Bauelement ein Mobiltelefon ist.

12. Das Kommunikationsgerät nach Anspruch 9, wobei das drahtlose Bauelement ein Personal Digital Assistant ist.

## Revendications

1. Oscillateur commandé en tension, comprenant :
un premier dispositif (102) ayant des première, deuxième et troisième bornes (102₁, 102₂, 102₃) ;
un deuxième dispositif (104) ayant des première, deuxième et troisième bornes (104₁, 104₂, 104₃) ; et
un ensemble de circuits comprenant un réseau de tension d'accord (120) couplé à des réseaux de résonateurs couplés accordés dynamiquement (124, 128), qui sont respectivement couplés aux troisièmes bornes (102₃, 104₃) de chacun des dispositifs (102, 104) et à un réseau de combineurs accordés dynamiquement (132), qui comporte deux ports d'entrée (132₁, 132₂) admettant un signal d'entrée respectif (138, 140) présent à la deuxième borne (102₂, 104₂) de chacun des dispositifs (102, 104) et qui combine les signaux d'entrée (138, 140) en un signal de sortie (150), moyennant quoi le réseau de combineurs accordés dynamiquement (132) est couplé au réseau de tension d'accord (120) pour renvoyer une partie sélectionnée d'un signal (154) du réseau de combineurs accordés dynamiquement (132) au réseau de tension d'accord (132),
dans lequel la tension du réseau d'accord (120) peut être réglée pour accorder le signal de sortie (150) de l'oscillateur commandé en tension sur une plage de fréquence d'au moins une octave

2. Oscillateur commandé en tension selon la revendication 1,
comprenant en outre un réseau de polarisation (112, 116) couplé entre les première et deuxième bornes (102₁, 102₂; 104₁, 104₂) des premier et deuxième dispositifs (102, 104).

3. Oscillateur commandé en tension selon la revendication 1,
dans lequel le signal de sortie (150) est accordable sur une plage de fréquence de fonctionnement qui fait le double de la fréquence fondamentale (2·f₀).

4. Oscillateur commandé en tension selon la revendication 1,
dans lequel les premier et deuxième dispositifs (102, 104) comprennent chacun des transistors bipolaires.

5. Oscillateur commandé en tension selon la revendication 1,
dans lequel les premier et deuxième dispositifs (102, 104) comprennent chacun des transistors à effet de champ.

6. Oscillateur commandé en tension selon la revendication 1,
dans lequel les réseaux de résonateurs accordables (124, 128) comprennent une paire de résonateurs couplés par microruban agencés en configuration fer à cheval.

7. Oscillateur commandé en tension selon la revendication 1
dans lequel le premier dispositif (102), le deuxième dispositif (104) et l'ensemble de circuits sont mis en œuvre dans un circuit intégré.

8. Oscillateur commandé en tension selon la revendication 1, comprenant en outre :
un ensemble de circuits (108) pour un couplage de phase accordable, un réseau couplé entre des premières bornes respectives (102₁, 104₁) du premier dispositif et du deuxième dispositif (102, 104).

9. Dispositif de communication réseau, le dispositif comprenant :
une boucle à verrouillage de phase pour générer un signal d'horloge utilisé pour transmettre ou récupérer des informations communiquées depuis ou vers le dispositif,
dans lequel la boucle à verrouillage de phase comporte un oscillateur commandé en tension, correspondant aux revendications 1 à 8, pour générer le signal d'horloge.

10. Dispositif de communication selon la revendication 9, dans lequel le dispositif de communication comprend un dispositif sans fil.

11. Dispositif de communication selon la revendication 9, dans lequel le dispositif sans fil est un téléphone cellulaire.

12. Dispositif de communication selon la revendication 9, dans lequel le dispositif sans fil est un assistant numérique personnel.
